(19) Europäisches Patentamt
European Patent Office
Office européen des brevets

(11) **EP 3 637 319 B1**

(12) **EUROPEAN PATENT SPECIFICATION**

(45) Date of publication and mention of the grant of the patent:
**25.05.2022 Bulletin 2022/21**

(21) Application number: **18199841.0**

(22) Date of filing: **11.10.2018**

(51) International Patent Classification (IPC):
**G06K 9/00** *(2022.01)* **G06K 9/48** *(2006.01)*
**G06K 9/52** *(2006.01)*

(52) Cooperative Patent Classification (CPC):
**G06V 20/64; G06V 10/42; G06V 10/478**

(54) **METHOD FOR GENERATING SHAPE DESCRIPTORS FOR TWO- OR THREE-DIMENSIONAL GEOMETRIC SHAPES**

VERFAHREN ZUM ERZEUGEN VON FORMBESCHREIBERN FÜR ZWEI- ODER DREIDIMENSIONALE GEOMETRISCHE FORMEN

PROCÉDÉ DE GÉNÉRATION DE DESCRIPTEURS DE FORME POUR DES FORMES GÉOMÉTRIQUES À DEUX OU TROIS DIMENSIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.04.2020 Bulletin 2020/16**

(73) Proprietor: **Honda Research Institute Europe GmbH**
**63073 Offenbach/Main (DE)**

(72) Inventor: **Schmitt, Dr. Sebastian**
**63073 Offenbach/Main (DE)**

(74) Representative: **Beder, Jens**
**Mitscherlich PartmbB**
**Patent- und Rechtsanwälte**
**Sonnenstraße 33**
**80331 München (DE)**

(56) References cited:
**WO-A1-2015/039054 US-A1- 2009 157 649**

• **MICHAEL KAZHDAN ET AL: "Rotation Invariant Spherical Harmonic Representation of 3D Shape Descriptors", PROCEEDINGS OF THE FOURTH EUROGRAPHICS SYMPOSIUM ON GEOMETRY PROCESSING ACM; INTERNATIONAL CONFERENCE PROCEEDING SERIES; SARDINIA, ITALY, JUNE 26 - 28, 2006, 25 June 2003 (2003-06-25), pages 156-164, XP055567035, Switzerland ISSN: 1727-8384 ISBN: 978-3-905673-13-5**

**Description**

The invention regards a computer-implemented method for processing of object designs in engineering by generating a set of unified efficient shape descriptors, which is helpful in order to enable engineers to efficiently optimize a shape of an objector, to retrieve a shape, or classify a plurality of shapes.

During the engineering design process of complex shapes, such as shapes of cars or turbo-fan engine blades, the crucial question exists how to represent all possible shapes for development and evaluation. In the context of shape optimization many different types of representations exist, prominent examples are direct parameterizations or various deformation methods. During a design process for a certain shape, many different geometries are created and their performance is evaluated in various disciplines, such as aerodynamic efficiency, crashworthiness, structural mechanical properties, thermal properties, noise, etc. In the course of the design process the type as well as the details of the representation usually changes frequently.

The complete set of geometries along with the evaluated performance data constitutes a very valuable dataset, which enables the engineers to generate novel insights and knowledge. In such a context machine learning offers very powerful tools for automatic data analysis and knowledge generation, such as prediction and classification models, or dimensionality reduction techniques. Usually, the parameters of the shape representation are used as the input values for such machine learning techniques. However, if representations of the shapes vary between different datasets, the direct application of machine learning techniques to the complete dataset using the representation parameters as inputs is not possible, even though they all encode the same type of geometric shape, which are in principle comparable to each other. The reason is that the meaning of the input parameters changes, as for example, in one representation the parameters encode the shape of the frontal part of a car, whereas in another representation the rear is encoded.

The alternative of directly using the coordinates of the entire shape geometry as input parameters for the machine learning has the major drawback that a huge training dataset with geometry and performance data is necessary, due to the very high dimensionality of the input parameter space. But in typical engineering applications, the generation of data is quite time and resource consuming and therefore the amount of data is usually rather limited in comparison to modern learning approaches, such as deep learning for 2D image data.

In order to tackle this problem, usually shape descriptors are used which encode the properties of a shape in a lower dimensional representation.

There exist many shape descriptors for two and three-dimensional shapes in the literature, as reviewed, for example, in "Survey on 3D Shape Descriptors" (L. Zhang, M. João da Fonseca, A. Ferreira, Internal Report Univ. Lisboa, POSC/EIA/59938/2004 (2004)). More recent approaches also utilize deep learning, see, for example, "Deepshape: Deep learned shape descriptor for 3D shape matching and retrieval" (J. Xie, Y. Fang, F. Zhu, E. Wong, IEEE Conference on Computer Vision and Pattern Recognition (CVPR), pp. 1275-1283 (2015) doi: 10.1109/CVPR.2015.7298732).

Shape descriptors can be grouped into two fundamental categories: local and global descriptors. Local descriptors work by determining some salient points on the shape and calculating features based on the geometry in the neighborhood of those key points. Global descriptors calculate features based on the complete shape or large parts of it.

Examples of global shape descriptors are transformation-based descriptors, such as Fourier descriptors as disclosed for example in "Efficient feature extraction for 2D/3D objects in mesh representation" (Zhang C, Chen T, IEEE International conference on Image Processing (2001). doi: 10.1109/ICIP.2001.958278), spherical harmonics descriptors and 3D Zernike moments as disclosed for example in "Survey on 3D Shape Descriptors" (L. Zhang, M. João da Fonseca, A. Ferreira, Internal Report Univ. Lisboa, POSC/EIA/59938/2004 (2004)). All these global shape descriptors sum over all points of the shape and transform them into a different representation by using some sort of kernel function. As a drawback, the known global descriptors suffer from a lack of local geometric information. Firstly, as a pre-processing step, the shape is either voxelized or some shape signatures such as centroid distances are derived which incorporates a loss of information about the local structure of the shape. Secondly, the individual entries in the actual feature vectors derived by using the actual transform are really global as each feature encodes one specific type of statistics of the complete shape without directly encoding local geometric information (of the already coarse-grained representation) as well. For example, Fourier shape descriptors encode the statistics of the wavelengths, that is, they encode which spatial variations occur when moving along the shape and how strong the signature of each wavelength is, i.e. a spectrum. The information about absolute positions in space and the correlated relative changes in a local neighborhood of the shape is distributed over the complete spectrum, i.e. in the complete feature vector. When truncating the spectrum by selecting only a small set of feature values (wavelengths), which is a necessary step to arrive at a manageable feature vector, some portion of such information is lost and it is a priori not clear what the implications are for the global and local representation of the shape. The equivalent insights apply to other transformation-based descriptors, such as Zernike moments, where the Zernike polynomials are used to decompose the shape, or spherical harmonics descriptors.

US patent application publication US 2009/0157649 A1 discloses a hybrid content-based three-dimensional model search and retrieval method for queries in generic three-dimensional model datasets. The hybrid nature of the method is two-fold. First, the method uses a combination of two-dimensional and three-dimensional features as the shape descriptor of a three-dimensional model and, second, the method employs two alternative alignment techniques, CPCA (continuous principal component analysis) and NPCA (normal principal components analysis), for rotation normalization. The two-dimensional features are Fourier coefficients extracted from three pairs of depth buffers, which are computed for each Cartesian plane capturing the models along each axis. The three-dimensional features are spherical harmonic coefficients extracted from a spherical function based representation that captures the model's surface as well as volume information.

It is thus an object of the present invention to provide a method for generating a set of shape descriptors for a set of two or three-dimensional geometric shapes as an efficient unified low-dimensional representation of a set of shapes that allows cost-efficient processing in an engineering process without losing information deriving from an entire set of shapes of objects.

This objective is achieved by a computer-implemented method for processing object designs in engineering as defined in claim 1.

Before aspects and details of the present invention are explained with respect to the figures, the basic idea underlying the set of feature descriptors shall be explained. With the method according to the present invention, discriminative features are calculated from 2D and 3D shapes. The basic idea for such calculation is that each point of the shape is assumed to emit one or more spherical wave, which are propagated throughout space with a spherical wave kernel $\frac{e^{ikr}}{r}$ or some slight modification of it. Each point of the shape emitting such spherical wave generates a complex-valued field, which decays with the distance from the point of the shape. At every position in space around the shape, the contributions of all the spherical waves emitted from each point of the shape add up. Due to their complex-valuedness they will generate an interference pattern throughout space which is characteristic of the shape.

Such a resulting interference pattern is used in order to represent a given shape. For such a given shape, feature descriptors are calculated for a set of $N$ feature locations positioned some distance away from the shape and distributed around the shape. Since contributions with different wave numbers can be associated with each point of the shape and each contribution decays with distance, the interference pattern at those feature locations will be very characteristic of the shape and the relative positon of the shape and the feature location. Generally, the feature descriptors are calculated for a set of $M$ wave numbers, so for each feature location $M$ feature descriptors are calculated resulting in $M \cdot N$ feature descriptors for one shape, i.e. a $M \cdot N$-dimensional feature vector which is the shape descriptor $\vec{F}$.

According to the inventive method a set of global shape descriptors for a set of two or three-dimensional geometric shapes is generated. At first, a set $\{\vec{R}_n\}$ of N feature locations is determined by an engineer, for example, and read in from a user interface or read from a memory. The feature locations have a distance from the shapes in the set of shapes and $\vec{R}_n$ is the position vector of the feature location having the length $R_n = |\vec{R}_n|$ and $n = 1, ..., N$. Additionally a set $\{k_m\}$ of M wave numbers with $m = 1, ..., M$ is determined by an engineer and read in via a user interface or also read from a memory. Further, a parameter $\gamma \in \mathbb{R}$ is read in, which is a parameter controlling a degree of locality of the features. This parameter may be read in directly from an interface where the respective value is input by an engineer, but may of course also be read in from a memory where for example a default value for the parameter is stored.

For each shape s of the set of shapes $\{S_s, s = 1, ..., N_s\}$ a feature descriptor is then calculated for each of the N feature locations and M wave numbers, according to the rule

$$f_s(n,m) = \left(\left\|\vec{R}_n\right\|_\alpha\right)^\gamma e^{-ik_m R_n} \int_{shape\ s} d^3\vec{s}\ \frac{e^{ik_m|\vec{s} - \vec{R}_n|}}{\left(\left\|\vec{s} - \vec{R}_n\right\|_\alpha\right)^\gamma}$$

where the integral is summing all contributions from each point of the shape s. Here, $\vec{s}$ is a position vector of points of the shape s, i is the imaginary unit, $\|\vec{x}\|_\alpha = [\Sigma_i(x_i)^\alpha]^{1/\alpha}$ is the $L\alpha$ norm of the vector $\vec{x}$. The now calculated feature descriptors are the elements of an $M \cdot N$ dimensional vector of features which is the shape descriptor for shape s. The feature descriptors for each shape are normalized to the volume or surface area of the respective shape, i.e. a normalization factor of $1/Vol_{shape\ s}$ (volume normalization) or $1/Area_{shape\ s}$ (area normalization) can be used for each feature descriptor. The feature descriptors are associated with the shape descriptor of shape s according to

$$\vec{F}_s = \left(f_s(n = 1, m = 1), f_s(n = 1, m = 2), ..., f_s(n = N, m = M)\right)^T$$

Finally, the set of shape descriptors for all shapes is output for further processing.

Each of the shape descriptors of the novel set of shape descriptors, which is generated by the inventive method is represented by a set of feature descriptors, that may also be called diffraction features, which can be derived from any geometry in a well-defined and straight-forward manner, and which encodes relevant local and global geometric aspects of each shape. The number of feature descriptors, i.e. the dimensionality of the shape descriptor, some qualitative aspects of the features, and the global properties of the set of shape descriptors can be adjusted freely and therefore enables the engineer to adjust it to the type and amount of available data, as well as to the requirements from the data management side for storage in memory and on disk, and to the future applications to be performed on the set of shape descriptors. The advantageous aspect of the inventive method is to enable effective storage, post-processing and information extraction for a possibly large set of large shapes in an improved and effective manner.

The shape descriptor as calculated by the inventive method is a global descriptor, where for each shape descriptor of each shape and for each entry in the vector, i.e. each feature descriptor the complete shape is taken into account. However, due to the fact that the distance between the feature location and the contribution of each part of each shape enters explicitly and, in particular, it's scaling with the inverse distance to the power of $\gamma$, each feature descriptor is rather sensitive to local changes. In particular, each entry in each shape descriptor is most sensitive to local changes of that region of the shape, which is spatially closest to its feature location.

The inventive method thus provides a low dimensional representation for a set of shapes that allows efficient computational processing while at the same time does not require omission of information due to voxelization or extracting statistics from the shapes like state of the art approaches, but instead always uses the complete information of the complete set of shapes.

In usual engineering applications, the shape data are provided as volume or surface meshes and an advantageous aspect of the present invention is that it can easily be adapted to such situations. For each feature descriptor of each shape $s$ in the set of shapes $\{S_s, s = 1, ..., N_s\}$ the integration over the shape is performed by summing over all mesh cells c of each shape where the contribution of each mesh cell $c$ is calculated using the center-of-mass coordinate of each cell, $\vec{s}_c$, and the volume- or area-weighted sum is taken over all mesh cells, i.e.,

$$f_s(n, m) = \left(\left\|\vec{R}_n\right\|_\alpha\right)^\gamma e^{-ik_m R_n} \sum_{mesh\ cells\ c\ of\ shape\ s} A_c \frac{e^{ik_m\left\|\vec{s}_c - \vec{R}_n\right\|_2}}{\left(\left\|\vec{s}_c - \vec{R}_n\right\|_\alpha\right)^\gamma}$$

where $A_c$ is the volume or area of the mesh cell $c$. Optionally, the entries of the feature vectors can also be normalized to the total volume or surface area of each shape, i.e. a factor of $1/Vol_{shape\ s}$ or $1/Area_{shape\ s}$ can be introduced.

The positions of the feature locations are chosen preferably to lie on a surface around the complete set of shapes. Preferred surfaces are for example a sphere with radius D, a cuboid with edge lengths A, B, and C, or a right circular cylinder with radius D and height H. The distribution of the points on the surface could be either deterministic, where the positions on the surface are calculated by a deterministic algorithm to follow a desired pattern or randomly, where the positions on the surface are determined by a randomized sampling technique in order to follow a desired distribution. The value for the center and the dimensions of such surfaces (radius D of the sphere, edge lengths A, B, and C of the cuboid, radius D and height H of the right circular cylinder) can be either given directly as absolute numbers or determined relative to the shapes by an algorithm, where, for example, the maximal linear length of each shape is calculated and then the parameters of the surface are set to a multiple of maximal length found for the complete set of shapes. In this case, the feature locations are chosen relative to the complete set of shapes and the variations of the positions of individual shapes within the set of shapes is encoded in the shape descriptors. Alternatively, the location of the shape features could be chosen relative to each shape in the set of shapes individually, which amounts to a normalization of the position of the feature location to each shape individually and removes the dependency of relative shifts between the shapes in the set of shapes from the shape descriptors.

The M wave numbers may be chosen to range from $k_{min}$ to $k_{max}$ and the spacing between the values may be chosen according to a desired behavior, for example, constant, linearly increasing or decreasing, exponentially increasing or decreasing, or user-defined values. It is additionally possible to add random noise of a defined strength to the values of the wave numbers. The values for $k_{min}$ and $k_{max}$ can be either specified directly as absolute numbers or calculated relative to each shape with an algorithm, where, for example, $k_{min}$ and $k_{max}$ are multiples of $\frac{2\pi}{L}$ and L is a length scale extracted from the set of shapes by determining the smallest sphere or cuboid which fully contains the set of shapes and then setting $L$ to the value of the radius or the largest edge length of such a minimal sphere or cuboid, respectively.

It is in particular preferred that the feature locations as well as the values for the wave numbers are determined by an optimization procedure which optimizes a desired property of the complete set of shape descriptors. For example, for a given set of shapes, the position vectors of the feature locations as well as the values for the wave numbers are optimized in order to maximize the mutual distances between the shape descriptors. Alternatively, for a given training set of shapes along with some class labels, the position vectors as well as the values for the wave numbers are optimized in order to maximize classification performance when applying a classification algorithm to the set of shape descriptors of the training set, which tries to determine the proper class label for each shape.

Advantageously, a pose-normalization procedure is applied to the shape descriptor of each shape in the set of shapes $\vec{F}_s$ in order to arrive at a normalized shape descriptor $\vec{F}_{s, final}$, which is then used for further processing. For example, a set of symmetry operations $\{R_b\}$ is included which map the set of feature locations $\{\overline{R}_n\}$ onto itself. The shape descriptors from one shape $\vec{F}_s$ of all those symmetry operations are considered equivalent and thus define the identity mapping on the final feature vector $\vec{F}_{s,final}$.

In order to minimize the computational cost for applications of the diffraction feature shape descriptors, for a given set of shapes the corresponding set of shape descriptors can be further processed by applying dimensionality reduction and manifold embedding techniques such as principal component analysis (PCA), independent component analysis (ICA), locally linear embedding (LLE), multi-dimensional scaling (MDS), Isomaps, or other linear or non-linear techniques. In this process the shape descriptor is reorganized and the dimensionality of each shape descriptor is possibly reduced from $M \cdot N$ to $D \leq M \cdot N$, which allows for an even more useful and compact low-dimensional representation of shapes for a given set of shapes.

The inventive method is further developed when the calculated set of shape descriptors (set of diffraction feature shape descriptors) are used as an input in a classification algorithm, which is thus run based on the respective shape descriptor. For a given set of shapes, which are organized in several categories the diffraction feature shape descriptor of one specific new shape is used to determine the category to which this newly observed shape belongs. The classification can either be done in a supervised manner, where a labeled training data set with shapes and their respective categories is used to train a classifier. Depending on the data set and the number of calculated feature descriptors, the classification algorithm can be any of the established algorithms such as linear classifiers, support vector machines, kernel estimation, decision trees, neural networks, learning vector quantization or deep learning convolutional neural network approaches to name a few. The classification can also be organized in an unsupervised manner, where the categories for the shapes as well as the classification of the newly observed shape are determined by a clustering algorithm, for example a density-based, distribution-based, centroid-based, or hierarchical clustering algorithm.

Alternatively, the set of diffraction feature shape descriptors may be used in a shape retrieval algorithm where for a given query shape the feature descriptors of that shape are used to find a set of similar shapes from the given set of shapes. The similarity of two shapes is evaluated by assessing the similarity of the two corresponding shape descriptors. For example, the absolute value (L2-norm) of a difference vector of the two shape descriptors of the two shapes can serve as a distance measure for the two shapes and shapes with smaller distances are considered more similar.

The set of diffraction feature shape descriptors may also be used in a surrogate-assisted shape optimization process. In such a context, a set of shape descriptors as described by this invention is calculated from the data from many shape optimization runs, possibly from different application fields (e.g., crash, aero-dynamics, structural mechanics, thermal analysis, noise-vibration-harshness, etc...), where quality criteria for many different shapes are determined, and this set is used to learn one or more surrogate models, which, given the diffraction feature shape descriptor of a new shape as input, will predict the performance values of the shape in one or more disciplines.

Explanations on an embodiment of the present invention will now be given with respect to the annexed drawings in which

Figure 1    illustrates feature locations arranged on a surface enclosing one respective shape of the set of shape to be represented, and

Figure 2    is a flowchart in which the main method steps according to the invention are illustrated.

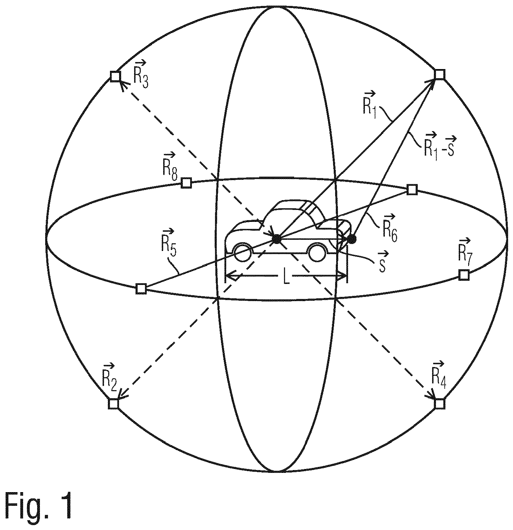

For a given set of shapes $\{S_s, s = 1, ..., N_s\}$ the set of shape descriptors $\{\vec{F}_s, s = 1, ..., N_s\}$ (i.e. the set of diffraction feature vectors) can be calculated in the following way which is explained with reference to figure 1. First, $N$ position vectors $\vec{R}_n$, where $n=\{1,...,N\}$ are chosen some distance away from the shapes $\{S_s\}$ and distributed all around the shapes. The position vectors $\vec{R}_n$ point to feature locations. As an example, figure 1 illustrates that the feature locations are chosen to all lie on a sphere where the length of $\vec{R}_n$ is fixed for all $n$, $|\vec{R}_n| = 5\,L$ and where $L$ is some characteristic length scale of some shape $S_s$ of the set of shapes, i.e. its maximum linear dimension. The distribution of the feature locations on the sphere could be chosen accordingly by using a regular grid in the azimuthal and polar angles or to be a Fibonacci lattice.

Then, a set of wave numbers is determined by the engineer, for example $\left\{ k_m = \frac{0.1}{M}\, m^2\, \frac{2\pi}{L} : m = \right.$

$$1, \dots, M\Big\}$$

where L is the characteristic length scale of the set of shapes $\{S_s\}$ determined above. Now, the complete set of diffraction feature shape descriptors $\{\vec{F}_s\}$ can be generated where each individual shape descriptor

$$\vec{F}_s = \big(f_s(1,1), f_s(1,2), \dots, f_s(1,M), f_s(2,1) \dots, f_s(N,M)\big)^T$$

of the shape $S_s$ is composed of feature descriptor $f_s(n, m)$, which are calculated according to the formula

$$f_s(n,m) = (R_n)^2\, e^{-ik_m R_n} \int_{shape\ s} d^3\vec{s}\ \frac{e^{ik_m|\vec{s}-\vec{R}_n|}}{|\vec{s}-\vec{R}_n|^2}$$

where $R_n = |\vec{R}_n| = 5L$ is the length (L2 norm) of the position vector of the feature location, $\vec{s}$ is a position vector of the points on the shape $S_s$ and the integral is summing all contributions from each point of the shape $S_s$. $i$ is the imaginary unit and $k_m$ the wave number. The pre-factor $(R_n)^\gamma\, e^{-ik_m R_n}$ is included to factor out the trivial far-field dependence of the features and its exponent $\gamma$ as well as the exponent of the denominator in the integral is set to 2 in the example in order to have a slightly larger bias toward local features as compared to choosing an exponent of 1 (which is the value for the wave kernel of physical light diffraction patterns). In order to adapt the degree of locality this exponent may be set by an engineer.

In typical engineering applications where the shapes are usually evaluated with respect to some performance using simulations such as computational fluid dynamics (CFD) or computations structural dynamics (CSD), the shape data is naturally provided as a volume or surface mesh. In such a case the integral over the shape can be represented as a sum over all mesh cells c and the contribution of each mesh cell $c$ is calculated using the center-of-mass coordinate of each cell, $\vec{s}_c$, and the volume- or area-weighted sum is taken over all mesh cells, i.e.,

$$f_s(n,m) = (R_n)^2\, e^{-ik_m R_n} \left( \sum_{mesh\ cells\ c\ of\ shape\ s} A_c\, \frac{e^{ik_m|\vec{s}_c-\vec{R}_n|}}{|\vec{s}_c-\vec{R}_n|^2} \right) \frac{1}{\sum_{mesh\ cells\ c\ of\ shape\ s} A_c}$$

where $A_c$ is the volume or area of the mesh cell c and the last factor realizes the normalization of the diffraction features to the volume or surface area of the shape.

Figure 1 shows an example for the positioning of the feature locations around one specific car shape S from the set of shapes. The maximal linear dimension **L** of the car shape S as well as the integration vector $\vec{s}$ running over the car shape is also indicated.

It is to be noted, that scale-invariance with respect to the overall scale of each shape S from the set of shapes is achieved if desired by using the normalization of the shape to the absolute surface area or volume of the shape, as indicated by the last factor in the above equation, and by calculating the maximal linear length L of each shape s and placing the feature locations on a sphere with a radius given in terms of this length L and also selecting the wave numbers dependent on this length scale.

Further, invariance of the features with respect to orientation of the shape can be achieved if desired by determining a set of symmetry transformations $\{R_b\}$ which map the set of feature locations onto itself, $\{R_b\colon \{R_n\} \to \{R_b(R_n)\} = R_n\}\}$. A symmetry-transformation just re-names the feature locations, i.e. permutes the ordering of the set of feature locations. All shape descriptors, which are produced under such symmetry transformation just have permuted entries and are considered as equivalent.

In combination, both measures realize pose normalization of the three-dimensional (3D) shape.

The set of shape descriptors $\{\overline{F}_s, s = 1, \dots, N_s\}$ of a set of shapes serves as a low-dimensional representation of the complete set of shapes and is, according to a preferred embodiment of the invention, used to build models which are trained to predict a performance of a new shape. Thus, one preferred embodiment regards multi-disciplinary shape optimization starting from an initial shape. For example, such optimization could be an optimization of the car body shape s for aerodynamic efficiency where drag should be minimized while certain other aspects of the flow should be maintained such as downforce in the rear part of the car. In addition to the aerodynamics, the structural mechanical properties of the car should also be optimized for supporting various given static loads cases. For such application, the car shape is parameterized by one or more methods most convenient for the development engineer of each discipline and such parameterization usually changes during such a process as different parts of the car are optimized separately in each discipline. The evaluation of the aerodynamic properties is done with computational fluid dynamics (CFD) and finite element method (FEM) simulations, for example.

A significant gain and speed-up in the individual disciplines, CFD or FEM, can already be achieved by utilizing surrogate models, which replace part of the actual CFD or FEM simulations and - after being trained on a set of simulation data obtained for a set of shapes - predict the aerodynamics and structural mechanics for new car shapes only using the efficient low-dimensional representation of the car shape as input. In order to utilize all available data, the efficient low-dimensional representation must represent the complete car geometry. Even further gain is possible by using a unified efficient low-dimensional representation, which can be utilized in multiple disciplines such as CFD of FEA simultaneously.

The proposed set of diffraction feature shape descriptors for a set of shapes is a very promising realization of such unified efficient low dimensional representations for a set of shapes. In such a scenario, the set of diffraction feature shape descriptors is calculated for a set of shapes generated during some initial phase of the design procedure. The dimensionality of each diffraction feature shape descriptor can be reduced by applying a dimensionality reduction technique such as principal component analysis or locally linear embedding to the complete set of shape descriptors. Then surrogate models, such as Gaussian process kriging models, support vector regressors, or random forest models are trained on the set of dimensionally reduced shape descriptors to predict the aerodynamic and structural mechanics performance given the dimensionality reduced diffraction feature shape descriptors of a new shape as input. Then, such models can be used in one of the many surrogate-assisted single-objective and multi-objective optimization approaches that are already known in the art. In such optimization approaches, for a newly proposed design the diffraction feature shape descriptor is calculated, the dimensionality reduction transformation is applied and then the surrogate models are used to estimate the aerodynamic and structural mechanics performance of the new shape, without running the resource consuming CFD or FEM simulations. Thus, a new car shape with improved aerodynamic and structural mechanics performance can be achieved with a numerical optimization approach, where depending on the details of the surrogate-assisted optimization algorithm, the number of necessary CFD and FEM simulations can be drastically reduced. Similar approaches can be taken for other and arbitrary number of disciplines, where this embodiment of the invention serves as the one unified efficient low-dimensional representation for a set of shapes.

One significant advantage of the shape descriptors generated by the invention used for such applications described above using CFD simulations in particular, is that the interference pattern encoded in the diffraction feature shape descriptors is sensitive to small changes of the geometry, which might have strong impact on the aerodynamics. But at the same time, the features are global in nature, where large scale changes are captured as well. And additionally, when used without any pose normalization, the features are sensitive to the absolute positioning and orientation of the shapes which is a very good aspect when used for modelling fluid flow around shapes or the effect static or dynamic directed forces have in a shape since in both applications the absolute orientation of the shapes is important.

According to another advantageous embodiment not covered by the claimed invention, the set of diffraction feature shape descriptors are used in shape matching or shape retrieval algorithms where similarities between shapes need to be assessed. This application is, for example, relevant in the engineering design process when an engineer develops a new shape and then tries to find similar shapes in the existing database of shapes, which were already evaluated in prior design processes. In a typical application we are given a set of shapes, $\{S_s , s = 1, ..., N_s\}$, which is for example the archive of already evaluated shapes, which we would like to partition into different categories and then allow for shape retrieval applications, where the most similar shape to a novel shape to arrive later is sought. First, the feature locations are chosen where the same feature locations and wave vectors will be used for all shapes. Then, for each shape $S_s$ the diffraction feature shape descriptor $\vec{F}_s$ is calculated. The set of shapes $\{S_s\}$ can then be partitioned into different categories by applying a clustering algorithm on the set of respective shape descriptors $\{\vec{F}_s , s = 1, ..., N_s\}$. For the subsequent shape retrieval application the query shape is evaluated with the clustering algorithm which was used to determine the categories and all shapes with the same class label are determined and considered as similar. The major advantage of the proposed set of diffraction feature shape descriptors calculated in the above described manner is that one unified set of shape descriptors can be used for all applications described above. For properly chosen feature locations, degree of locality and wave numbers, the one set of shape descriptor $\{\vec{F}_s , s = 1, ..., N_s\}$ calculated once for the associated set of shapes $\{S_s , s = 1, ..., N_s\}$ can be simultaneously used for all types of applications, such as shape classification, shape retrieval, performance prediction of new shapes, surrogate assisted shape optimization, and more. This is enabled by the global nature of the shape descriptors, which are at the same time sensitive to local changes of shapes due to the interference and complex valuedness of the shape descriptors.

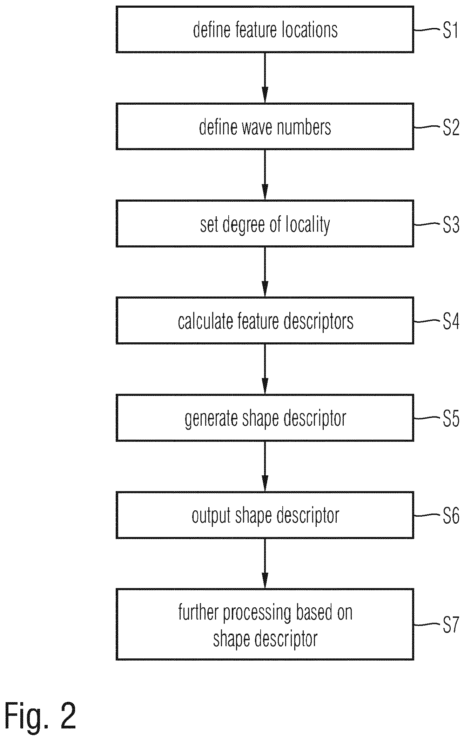

In figure 2 there is shown a simplified flowchart to illustrate the main method steps according to the invention. At first in step S1 the feature locations are defined. Then, in step S2 the wave numbers are defined. It is to be noted that, of course, the sequence of the first two method steps S1 and S2 may be altered. Further, in step S3 the degree of locality is set. According to one aspect of the invention, all these inputs that are necessary in order to calculate the set of feature descriptors in step S4 may be read in from a memory, which is part of a computer system that is used in order to calculate the feature descriptors and later on to generate the set of shape descriptors $\{\vec{F}_s\}$ from the feature descriptors. The computer furthermore includes a processor connected to the memory where the calculation of the feature descriptors is done and also the generation of the set of shape descriptors $\{\vec{F}_s\}$.

Alternatively, the definition of the feature location, the wave numbers and the degree of locality could be input into the computer system directly by an engineer via an interface.

After the feature descriptors have been calculated for each shape s, they are assigned to elements of feature vector, in order to generate the set of shape descriptors $\{\vec{F}_s\}$ in step S5. The set of shape descriptors $\{\vec{F}_s\}$ is then output either directly into an algorithm where, based on the set of shape descriptors $\{\vec{F}_s\}$, further processing is performed, for example in order to perform shape matching or retrieval of the shape, or to perform surrogate-assisted optimization as already mentioned above in greater detail. Of course, the set of shape descriptors $\{\vec{F}_s\}$ may also be stored in the memory of the computer system.

**Claims**

1. A computer-implemented method for processing object designs in engineering by generating a set of shape descriptors $\{\vec{F}_s, s = 1, ..., N_s\}$ for a set of two or three dimensional geometric shapes, comprising the following steps:

   - reading a set $\{\vec{R}_n\}$ of N feature locations, wherein $\vec{R}_n$ is the position vector of a feature location having the length $R_n = |\vec{R}_n|$ and $n = 1, ..., N$ (S1);
   - reading (S2) a set $\{k_m\}$ of M wave numbers, wherein $m = 1, ..., M$;
   - reading (S3) $\gamma \in \mathbb{R}$, which is a parameter controlling a degree of locality of the features;
   - for each shape s calculating (S4) for each of the N feature locations $\vec{R}_n$ and M wave numbers $k_m$ a feature descriptor $f_s(n,m)$ according to the rule

$$f_s(n,m) = \left( \left\| \vec{R}_n \right\|_\alpha \right)^\gamma e^{-ik_m R_n} C \int_{shape\, s} d^3\vec{s} \; \frac{e^{ik_m \left\| \vec{s} - \vec{R}_n \right\|_2}}{\left( \left\| \vec{s} - \vec{R}_n \right\|_\alpha \right)^\gamma}$$

   wherein the integral is summing all contributions from each point of the shape s,

   $\vec{s}$ is a position vector of points of the shape,
   i is the imaginary unit,
   $\left\| \vec{x} \right\|_\alpha = \left[ \sum_i (x_i)^\alpha \right]^{1/\alpha}$ is the $L_\alpha$ norm of the vector $\vec{x}$, and
   C is a normalization constant which can be chosen either $C = 1$ or to normalize the feature to the absolute volume or surface area of the shape: $C = 1/\int_{shape\, s} d^3\vec{s}$.;

   - assigning (S5) the calculated feature descriptors $f_s(n,m)$ to an $M \cdot N$ dimensional vector of features as the shape descriptor $\vec{F}_s$ according to

$$\vec{F}_s = \left( f_s(n = 1, m = 1), f_s(n = 1, m = 2), ..., f_s(n = N, m = M) \right)^T;$$

   and
   - outputting (S6) the set of shape descriptors $\{\vec{F}_s, s = 1, ..., N_s\}$ for further processing.

2. The computer-implemented method according to claim 1, wherein data of the shapes is provided as a volume or surface mesh and for each feature descriptor the integral is calculated according to

$$C \int_{shape\ s} d^3\vec{s}\ \frac{e^{ik_m\|\vec{s}-\vec{R}_n\|_2}}{\left(\|\vec{s}-\vec{R}_n\|_\alpha\right)^\gamma} \Rightarrow C \sum_{mesh\ cells\ c\ of\ s} A_c\ \frac{e^{ik_m\|\vec{s}_c-\vec{R}_n\|_2}}{\left(\|\vec{s}_c-\vec{R}_n\|_\alpha\right)^\gamma}$$

wherein c are the mesh cells *c* of shape *s,*

$\vec{s}_c$ is a center-of-mass coordinate of the respective cell c,

$A_c$ is the volume or area of the respective mesh cell *c,* and

*C* is a normalization constant which can be chosen either *C*=1 or to normalize the feature to the absolute volume or surface area of the shape:

$$C = 1/\textstyle\sum_{mesh\ cells\ c\ of\ s} A_c\ .$$

3. The computer-implemented method according to claim 1 or 2, wherein positions of the feature locations lie on a surface around the shapes with the feature locations being calculated by a deterministic algorithm to follow a desired pattern or randomly, where the positions of the feature locations on the surface are determined by a randomized sampling technique in order to follow a desired distribution.

4. The computer-implemented method according to any one of claims 1 to 3, wherein the *M* wave numbers are chosen to range from $k_{min}$ to $k_{max}$ and a spacing between values of the wave numbers is constant, linearly increasing, linearly decreasing, exponentially increasing, exponentially decreasing or explicitly given by a user.

5. The computer-implemented method according to claim 4, wherein random noise of a defined strength can also be added to the values of the wave numbers.

6. The computer-implemented method according to any one of claims 1 to 5, wherein a dimensionality reduction or embedding technique is used to transform the complete set of shape descriptors $\{\vec{F}_s\}$ and possibly reduce the dimensionality of each shape descriptor $\vec{F}_s$ in the set of shape descriptors.

7. The computer-implemented method according to any one of claims 1 to 6, wherein the feature locations and/or the values for the wave numbers are determined by an optimization algorithm.

8. The computer-implemented method according to any one of claims 1 to 7, wherein a pose-normalization procedure is applied to each shape descriptor in the set of shape descriptors $\{\vec{F}_s, s = 1, ..., N_s\}$ (S7).

9. The computer-implemented method according to any one of claims 1 to 8, wherein a classification algorithm is run based on the calculated set of shape descriptors $\{\vec{F}_s, s = 1, ..., N_s\}$ (S7).

10. The computer-implemented method according to any one of claims 1 to 8, wherein shape retrieval is performed based on the set of shape descriptors

$$\{\vec{F}_s, s = 1, ..., N_s\}\ (S7).$$

11. The computer-implemented method according to any one of claims 1 to 8, wherein a performance prediction process is performed which could be integrated into a surrogate-assisted shape optimization process based on the calculated set of shape descriptors $\{\vec{F}_s, s = 1, ..., N_s\}$ (S7).

**Patentansprüche**

1. Computerimplementiertes Verfahren zur Verarbeitung von Objektdesigns in der technischen Entwicklung durch Erzeugen eines Satzes von Formdeskriptoren {$\vec{F}_s$, s = 1, ..., $N_s$} für einen Satz von zwei- oder dreidimensionalen geometrischen Formen, aufweisend die folgenden Schritte:

- Lesen (S1) eines Satzes {$\vec{R}_n$} von N Merkmals-Orten, wobei $\vec{R}_n$ den Positionsvektor eines Merkmals-Ortes mit der Länge $R_n = |\vec{R}_n|$ und n = 1, ..., N darstellt;
- Lesen (S2) eines Satzes {$k_m$} von M Wellenzahlen, wobei m = 1, ..., M;
- Lesen (S3) von $\gamma \in \mathbb{R}$ , welches einen Parameter darstellt, der den Grad der Lokalisierung der Merkmale steuert;
- für jede Form s, Berechnen (S4) eines Merkmalsdeskriptors $k_m\, f_s(n, m)$ für jeden der N Merkmals-Orte $\vec{R}_n$ und M Wellenzahlen, gemäß der Beziehung

$$f_s(n,m) = \left(\left\|\vec{R}_n\right\|_\alpha\right)^\gamma \, e^{-ik_m R_n}\, C \int_{Form\, s} d^3\vec{s}\, \frac{e^{ik_m\left\|\vec{s}-\vec{R}_n\right\|_2}}{\left(\left\|\vec{s}-\vec{R}_n\right\|_\alpha\right)^\gamma}$$

wobei gilt: das Integral ist die Summe aller Beiträge von jedem Punkt der Form s;

$\vec{s}$ ist ein Positionsvektor von Punkten der Form;
i stellt die imaginäre Einheit dar; $\|\vec{x}\|_\alpha = [\Sigma_i (x_i)^\alpha]^{1/\alpha}$ ist die $L_\alpha$ Norm des Vektors $\vec{x}$ ; und
C ist eine Normierungskonstante, die entweder gemäß C =**1** oder zur Normierung des Merkmals auf das absolute Form-Volumen oder die absolute Form-Oberfläche gemäß C = 1/$\int_{Form\, s} d^3\vec{s}$ gewählt werden kann;

- Zuweisen (S5) der berechneten Merkmalsdeskriptoren $f_s(n, m)$ zu einem $M \cdot N$ dimensionalen Merkmalsvektor als Formdeskriptor $\vec{F}_s$ gemäß der Beziehung

$$\vec{F}_s = \left(f_s(n = 1, m = 1), f_s(n = 1, m = 2), ..., f_s(n = N, m = M)\right)^T;$$

und
- Ausgeben (S6) des Satzes von Formdeskriptoren {$\vec{F}_s$, s = 1, ..., $N_s$} zur weiteren Verarbeitung.

**2.** Computerimplementiertes Verfahren nach Anspruch **1**,
wobei die Daten der Formen als ein Volumen- oder Oberflächennetz bereitgestellt werden und für jeden Merkmalsdeskriptor das Integral berechnet wird, gemäß der Beziehung

$$C \int_{Form\, s} d^3\vec{s}\, \frac{e^{ik_m\left\|\vec{s}-\vec{R}_n\right\|_2}}{\left(\left\|\vec{s}-\vec{R}_n\right\|_\alpha\right)^\gamma} \Rightarrow C \sum_{Maschenzellen\, c\, von\, s} A_c\, \frac{e^{ik_m\left\|\vec{s}_c-\vec{R}_n\right\|_2}}{\left(\left\|\vec{s}_c-\vec{R}_n\right\|_\alpha\right)^\gamma}$$

wobei c die Maschenzellen c der Form s darstellen,

$\vec{s}_c$ eine Schwerpunktskoordinate der jeweiligen Zelle c darstellt,
$A_c$ das Volumen oder die Fläche der jeweiligen Maschenzelle c darstellt, und
C eine Normierungskonstante darstellt, wobei entweder C =**1** gewählt werden kann oder zur Normierung des Merkmals auf das absolute Form-Volumen oder die absolute Form-Oberfläche gemäß C = 1/$\Sigma_{Maschenzellen\, c\, von\, s} A_c$ gewählt werden kann.

**3.** Computerimplementiertes Verfahren nach Anspruch **1** oder 2,
wobei sich die Positionen der Merkmals-Orte auf einer Oberfläche der Formen befinden, wobei die Merkmals-Orte, um einem gewünschten Muster zu folgen, durch einen deterministischen Algorithmus berechnet werden oder zufällig ausgewählt werden, wobei die Positionen der Merkmals-Orte auf der Oberfläche durch ein Zufallsstichprobenverfahren bestimmt werden, um einer gewünschten Verteilung zu entsprechen.

**4.** Computerimplementiertes Verfahren nach einem der Ansprüche 1 bis 3,
wobei die M Wellenzahlen so gewählt werden, dass sie im Bereich von $k_{min}$ bis $k_{max}$ liegen und ein Abstand zwischen den Werten der Wellenzahlen konstant, linear ansteigend, linear abnehmend, exponentiell ansteigend, exponentiell abnehmend oder explizit von einem Benutzer vorgegeben ist.

5. Computerimplementiertes Verfahren nach Anspruch 4,
   wobei zu den Werten der Wellenzahlen auch Zufallsrauschen einer definierten Stärke addiert werden kann.

6. Computerimplementiertes Verfahren nach einem der Ansprüche 1 bis 5,
   wobei eine Dimensionalitätsreduktions- oder Einbettungsmethode verwendet wird, um den vollständigen Satz von Formdeskriptoren $\{\vec{F}_s\}$ zu transformieren und möglicherweise die Dimensionalität jedes Formdeskriptors $\vec{F}_s$ in dem Satz von Formdeskriptoren zu reduzieren.

7. Computerimplementiertes Verfahren nach einem der Ansprüche 1 bis 6,
   wobei die Merkmals-Orte und/oder die Werte für die Wellenzahlen durch einen Optimierungsalgorithmus bestimmt werden.

8. Computerimplementiertes Verfahren nach einem der Ansprüche 1 bis 7,
   wobei auf jeden Formdeskriptor in dem Satz von Formdeskriptoren $\{\overline{F}_s, s = 1, ..., N_s\}$ ein Verfahren zur Lage-Normierung angewendet wird ($S_7$).

9. Computerimplementiertes Verfahren nach einem der Ansprüche 1 bis 8,
   wobei ein Klassifizierungsalgorithmus auf der Grundlage des berechneten Satzes von Formdeskriptoren $\{\overline{F}_s, s = 1, ..., N_s\}$ ausgeführt wird ($S_7$).

10. Computerimplementiertes Verfahren nach einem der Ansprüche 1 bis 8,
    wobei die Formenfindung auf der Grundlage des Satzes von Formdeskriptoren $\{\vec{F}_s, s = 1, ..., N_s\}$ durchgeführt wird ($S_7$).

11. Computerimplementiertes Verfahren nach einem der Ansprüche 1 bis 8,
    wobei ein Leistungsprognoseprozess durchgeführt wird, der in einen Surrogat-unterstützten Formoptimierungsprozess auf der Grundlage des berechneten Satzes von Formdeskriptoren $\{\overline{F}_s, s = 1, ..., N_s\}$ integriert werden könnte ($S_7$).

**Revendications**

1. Procédé mis en œuvre par ordinateur pour traiter des conceptions d'objets dans l'ingénierie en générant un ensemble de descripteurs de forme $\{\vec{F}_s, s = 1, ..., N_s\}$ pour un ensemble de formes géométriques bidimensionnelles ou tridimensionnelles, comprenant les étapes suivantes :

   - lire un ensemble $\{\vec{R}_n\}$ de N emplacements de caractéristiques, dans lequel $\vec{R}_n$ est le vecteur de position d'un emplacement de caractéristiques ayant la longueur $\overline{R}_n = |\vec{R}_n|$ et $n = 1, ..., N$(S1) ;
   - lire (S2) un ensemble $\{K_m\}$ de M nombres d'ondes, dans lequel $m = 1, ..., M$ ;

   - lire ($S_3$) $\gamma \in \mathbb{R}$, qui est un paramètre commandant un degré de localité des caractéristiques ;
   - pour chaque forme s (*shape s* dans les formules) calculer ($S_4$) pour chacun des N emplacements de caractéristiques $\vec{R}_n$ et M nombres d'ondes $k_m$ un descripteur de caractéristiques $f_s(n, m)$ selon la règle

$$f_s(n,m) = \left(\|\vec{R}_n\|_\alpha\right)^\gamma \; e^{-ik_m R_n} \; C \int_{shape\, s} d^3\vec{s} \; \frac{e^{ik_m\|\vec{s}-\vec{R}_n\|_2}}{\left(\|\vec{s}-\vec{R}_n\|_\alpha\right)^\gamma}$$

dans laquelle l'intégrale est la somme de toutes les contributions de chaque point de la forme s,

$\vec{s}$ est un vecteur de position de points de la forme,

i est l'unité imaginaire,

$\|\vec{x}\|_\alpha = [\Sigma_i(x_i)^\alpha]^{1/\alpha}$ est la norme $L_\alpha$ du vecteur $\vec{x}$, et

$C$ est une constante de normalisation qui peut être choisie soit $C = 1$, soit pour normaliser la caractéristique au volume absolu ou à la superficie de surface absolue de la forme : $C = 1/\int_{shape\ s} d^3\vec{s}$;

- attribuer (S5) les descripteurs de caractéristiques $f_s(n,m)$ calculés à un vecteur dimensionnel $M \cdot N$ de caractéristiques en tant que descripteur de forme $\vec{F}_s$ selon

$$\vec{F}_s = \left(f_s(n=1, m=1), f_s(n=1, m=2), ..., f_s(n=N, m=M)\right)^T$$

; et

- délivrer (S6) l'ensemble de descripteurs de forme $\{\vec{F}_s, s = 1, ..., N_s\}$ pour un traitement ultérieur.

**2.** Procédé mis en oeuvre par ordinateur selon la revendication 1,
dans lequel les données des formes sont fournies sous la forme d'un maillage de volume ou de surface et pour chaque descripteur de caractéristiques l'intégrale est calculée selon

$$C \int_{shape\ s} d^3\vec{s}\ \frac{e^{ik_m\|\vec{s} - \vec{R}_n\|_2}}{\left(\|\vec{s} - \vec{R}_n\|_\alpha\right)^\gamma} \Rightarrow C \sum_{mesh\ cells\ c\ of\ s} A_c\ \frac{e^{ik_m\|\vec{s}_c - \vec{R}_n\|_2}}{\left(\|\vec{s}_c - \vec{R}_n\|_\alpha\right)^\gamma}$$

dans laquelle c représente les cellules de maillage c (*mesh cells c* dans les formules) de la forme s,

$\vec{s}_c$ est une coordonnée du centre de masse de la cellule c respective,

$A_c$ est le volume ou la superficie de la cellule de maillage c respective, et

$C$ est une constante de normalisation qui peut être choisie soit $C = 1$, soit pour normaliser la caractéristique au volume absolu ou à la superficie de surface absolue de la forme : $C = 1/\Sigma_{mesh\ cells\ of\ s}\ A_c$.

**3.** Procédé mis en oeuvre par ordinateur selon la revendication 1 ou 2,
dans lequel les positions des emplacements de caractéristiques se trouvent sur une surface autour des formes avec les emplacements de caractéristiques qui sont calculés par un algorithme déterministe pour suivre un motif souhaité ou de manière aléatoire, où les positions des emplacements de caractéristiques sur la surface sont déterminées par une technique d'échantillonnage réparti aléatoirement afin de suivre une répartition souhaitée.

**4.** Procédé mis en oeuvre par ordinateur selon l'une quelconque des revendications 1 à 3, dans lequel les M nombres d'ondes sont choisis pour être compris entre $k_{min}$ et $k_{max}$ et un espacement entre les valeurs des nombres d'ondes est constant, linéairement croissant, linéairement décroissant, exponentiellement croissant, exponentiellement décroissant ou explicitement donné par un utilisateur.

**5.** Procédé mis en oeuvre par ordinateur selon la revendication 4,
dans lequel un bruit aléatoire d'une force définie peut également être ajouté aux valeurs des nombres d'ondes.

**6.** Procédé mis en oeuvre par ordinateur selon l'une quelconque des revendications 1 à 5, dans lequel une technique de réduction ou d'incorporation de la dimensionnalité est utilisée pour transformer l'ensemble complet de descripteurs de forme $\{\vec{F}_s\}$ et éventuellement réduire la dimensionnalité de chaque descripteur de forme $\vec{F}_s$ dans l'ensemble de descripteurs de forme.

**7.** Procédé mis en oeuvre par ordinateur selon l'une quelconque des revendications 1 à 6,
dans lequel les emplacements de caractéristiques et/ou les valeurs des nombres d'ondes sont déterminés par un algorithme d'optimisation.

**8.** Procédé mis en oeuvre par ordinateur selon l'une quelconque des revendications 1 à 7, dans lequel une procédure de normalisation de pose est appliquée à chaque descripteur de forme dans l'ensemble de descripteurs de forme $\{\vec{F}_s,\ s = 1,\ ...,\ N_s\}$ (S$_7$).

9. Procédé mis en oeuvre par ordinateur selon l'une quelconque des revendications 1 à 8, dans lequel un algorithme de classification est exécuté sur la base de l'ensemble calculé de descripteurs de forme $\{\vec{F}_s,\ s = 1,\ ...,\ N_s\}$ (S$_7$).

10. Procédé mis en oeuvre par ordinateur selon l'une quelconque des revendications 1 à 8, dans lequel la recherche de forme est réalisée sur la base de l'ensemble de descripteurs de forme $\{\vec{F}_s,\ s = 1,\ ...,\ N_s\}$ (S$_7$).

11. Procédé mis en oeuvre par ordinateur selon l'une quelconque des revendications 1 à 8, dans lequel on réalise un processus de prédiction de performance qui pourrait être intégré dans un processus d'optimisation de forme assisté par un substitut sur la base de l'ensemble calculé de descripteurs de forme $\{\vec{F}_s,\ s = 1,\ ...,\ N_s\}$ (S$_7$).

Fig. 1

```
┌─────────────────────────────────┐
│      define feature locations   │──S1
└─────────────────────────────────┘
                │
                ▼
┌─────────────────────────────────┐
│       define wave numbers       │──S2
└─────────────────────────────────┘
                │
                ▼
┌─────────────────────────────────┐
│       set degree of locality    │──S3
└─────────────────────────────────┘
                │
                ▼
┌─────────────────────────────────┐
│    calculate feature descriptors │──S4
└─────────────────────────────────┘
                │
                ▼
┌─────────────────────────────────┐
│     generate shape descriptor   │──S5
└─────────────────────────────────┘
                │
                ▼
┌─────────────────────────────────┐
│      output shape descriptor    │──S6
└─────────────────────────────────┘
                │
                ▼
┌─────────────────────────────────┐
│     further processing based on │──S7
│         shape descriptor        │
└─────────────────────────────────┘
```

# Fig. 2

## REFERENCES CITED IN THE DESCRIPTION

**Patent documents cited in the description**

- US 20090157649 A1

**Non-patent literature cited in the description**

- **L. ZHANG ; M. JOÃO DA FONSECA ; A. FERREI-RA.** Survey on 3D Shape Descriptors. *Internal Report Univ. Lisboa, POSC/EIA/59938/2004,* 2004

- **J. XIE ; Y. FANG ; F. ZHU ; E. WONG.** Deepshape: Deep learned shape descriptor for 3D shape matching and retrieval. *IEEE Conference on Computer Vision and Pattern Recognition (CVPR),* 2015, 1275-1283
- **ZHANG C ; CHEN T.** Efficient feature extraction for 2D/3D objects in mesh representation. *IEEE International conference on Image Processing,* 2001